Europäisches Patentamt

European Patent Office

Office européen des brevets

(19)

(11) Publication number: **0 136 888**
**B1**

(12) EUROPEAN PATENT SPECIFICATION

(45) Date of publication of patent specification: 02.03.88

(51) Int. Cl.⁴: **H 01 L 23/50, H 01 L 27/04**

(21) Application number: 84306613.5

(22) Date of filing: 28.09.84

(54) Large scale integration circuitry.

(30) Priority: 30.09.83 JP 181932/83

(43) Date of publication of application:
10.04.85 Bulletin 85/15

(45) Publication of the grant of the patent:
02.03.88 Bulletin 88/09

(84) Designated Contracting States:
DE FR GB

(56) References cited:
EP-A-0 074 805
DD-A- 152 234

PATENT ABSTRACTS OF JAPAN vol. 7, no. 236,
20th October 1983, page (E205) (1381); &
JP-A-58-124262 (NIPPON DENKI) 23-07-1983

(73) Proprietor: FUJITSU LIMITED
1015, Kamikodanaka Nakahara-ku
Kawasaki-shi Kanagawa 211 (JP)

(72) Inventor: Shimauchi, Yoshiki c/o Fujitsu Limited
Patent Department 1015 Kamikodanaka
Nakahara-ku Kawasaki-shi Kanagawa 211 (JP)

(74) Representative: Sunderland, James Harry et al
HASELTINE LAKE & CO Hazlitt House 28
Southampton Buildings Chancery Lane
London WC2A 1AT (GB)

# Description

This invention relates to large scale integration circuitry, and in particular to the pattern layout of a large scale integration (LSI) device chip.

For example, masterslice semiconductor technology has been proposed as a means for providing custom-tailored large scale integration (LSI) semiconductor circuits (LSI device chips) at a low cost and with a short turnaround time. With this technology a large number of elements (transistors and resistors) are formed in a semiconductor chip in advance, and these elements are then interconnected by the use of masks having wiring patterns as necessary for realizing a functional circuit meeting a customer's specific requirements.

With an LSI chip it is required to drive circuits external to the chip by means of output transistors provided on the LSI chip. These output transistors are provided in "external" cells of an LSI chip in accordance with a previous proposal described below. When the output transistors of the external cells of such an LSI chip are operated large quantities of noise may be generated which can decrease reliability of operation of the LSI chip.

EP—A—74 805 discloses an LSI device chip having the features of the pre-characterising part of claim 1.

According to the present invention there is provided an LSI device chip, having

an internal cell area, arranged inwardly of the chip, comprising a plurality of internal cells, and

an external cell area, arranged outwardly of the internal cell area, comprising a plurality of external cells, with

a bonding pad area, arranged outwardly of the internal cell area;

an inner reference voltage line, arranged inwardly of the bonding pad area, and connected to internal cells, characterised in that

a reference voltage supply pad, to which the inner reference voltage line is connected, is disposed in the bonding pad area,

an outer reference voltage line is provided, arranged outwardly of the bonding pad area, connected to said reference voltage supply pad and to external cells, and

the external cell area comprises an outer area arranged outwardly of the bonding pad area, the bonding pad area, and an inner area arranged inwardly of the bonding pad area.

An embodiment of the present invention can provide a large scale integration (LSI) circuit in which noise generated by switching of high current by output transistors is reduced.

In an embodiment of the present invention pattern layout technology is provided for an LSI circuit such that noise generated by an increase of drive activity of output transistors is reduced.

An embodiment of the present invention affords an improved pattern layout of an LSI device chip. The chip comprises mainly an internal cell array, a bonding pad array and an external cell array. The internal cell array, arranged centrally of the chip, is composed of small current transistors. The external cell array, arranged outwardly of the internal cell array, comprises large transistors for driving external circuits. A bonding pad array, arranged outwardly of the internal cell array, comprises a reference voltage supply pad and a signal pad. The external cell array area is separated from the internal cell array area by the bonding pad array area. An inner reference voltage line, located inwardly of the bonding pad array, is connected to the reference (power) voltage supply pad and the internal cells. An outer reference voltage line, located outwardly of the bonding pad array, is connected to the external cells and the reference (power) voltage supply pad.

With this layout of the chip, since the outer reference voltage line connected to external cells, the source of the noise to be reduced as explained below, is separated from the inner reference voltage line connected to internal cells, the effects of generation of noise in the external cells are kept away from the internal cells. Threfore, circuitry formed by the internal cells can be operated without being affected by the noise generated in the external cells, so the reliability of the device is improved.

Reference is made, by way of example, to the accompanying drawings, in which:—

Figure 1A is a diagrammatic plan view of an exemplary, previously proposed, gate array layout pattern,

Figure 1B is a diagrammatic plan view of an exemplary gate array layout pattern formed by use of layout technology in accordance with an embodiment of the present invention,

Figure 2 is a schematic plan view showing in more detail the pattern of Figure 1B,

Figure 3A is a view to a larger scale of a part of Figure 2, showing in plan internal cell array and external cell areas,

Figure 3B is an enlarged cross-sectional view taken along the line D—E in Figure 3A;

Figure 4 is a schematic block diagram illustrating reference voltage line connection in a previously proposed pattern layout for an LSI chip.

Figure 5 is a schematic block diagram illustrating reference voltage line connection in accordance with an embodiment of the present invention,

Figure 6 is a schematic circuit diagram of an internal cell provided in the pattern shown in Figure 2, with reference voltage line connection in accordance with an embodiment of the present invention, and

Figure 7 is a schematic circuit diagram of an external cell, in accordance with Figure 3 or Figure 5, with reference voltage line connection in accordance with an embodiment of the present invention.

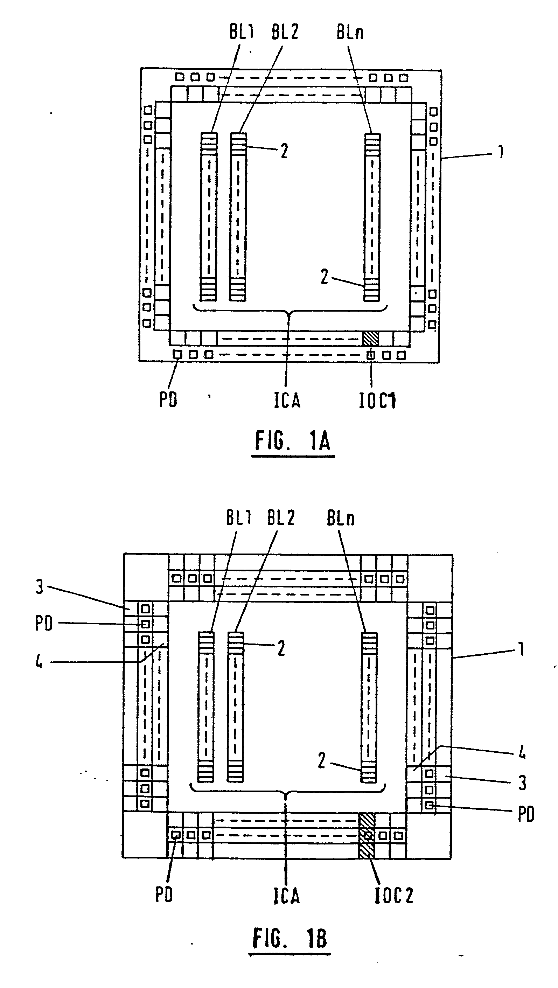

In the previously proposed gate array pattern layout shown in Figure 1A, on a semiconductor substrate chip 1 cells 2 are arranged in columns to constitute cell arrays $BL_1$, $BL_2$, ... $BL_n$. Each of the

cells 2, in general, comprises TTL (Transistor Transistor Logic) circuits, or ECL (Emitter Coupled Logic) circuits or CMIS (Complementary Metal Oxide Insulated Semiconductor circuits).

The following description is given primarily with regard to gate array LSI's using TTR circuits.

The cells 2 are spaced from each other in respective cell arrays BL with a specified spacing therebetween, and the cells are arranged in rows from one cell array to the next. The spaces between adjacent cell arrays are used for distributing wiring lines for interconnecting cells in a cell array and/or cells in different cell arrays.

The cells 2 are "internal" cells lying in an internal cell area ICA within which main logic circuitry of the IC on the chip 1 is formed.

At the periphery of the chip 1, outside the internal cell area ICA, there is provided a pad area PD, for pads used to connect the IC on the chip to external circuits. Within pad area PD, there is included an external cell area IOC1, which is allotted for occupancy by "external" cells containing input/output (I/O) circuits in the previously proposed layout of Fig. 1A.

With this pattern layout, circuitry in the internal cell area ICA, which is used to provide main logic circuitry of the IC, is often affected by noise, and large quantities of noise may be generated in the pattern layout of Fig. 1A when output transistors in external cells are operated.

It has been found that this noise is due to variations of earth potential resulting from large currents of output transistors flowing through an earth wiring line. The fluctuation of the earth potential disturbs the performance of the LSI and causes the noise, and reliability suffers. Thus, switching noise mainly caused by variation of earth potential due to switching of large currents by output transistors in I/O circuits has undesirable effects with the pattern layout of Fig. 1A.

The same reference signs are used in Fig. 1B and Fig. 1A to represent similar parts.

In an exemplary gate array pattern formed in accordance with the layout technology of an embodiment of the present invention, illustrated in Fig. 1B, as compared with the previous gate array pattern layout of Fig. 1A in which a common earth reference voltage line (not shown) is provided for the internal cells (2) and the external cells, an earth reference voltage line (not shown) for external cells, especially for output transistors, is separated from an earth reference voltage line for internal cells, so that noise generated in the external cells does not affect the internal cells.

Also, in the embodiment of the present invention, an external cell area IOC2 is constituted of three areas, namely an outer area 3, a bonding pad area PD, and an inner area 4. The outer area 3, in which large currents are handled, is separated from the inner area 4, which latter area might be seen to correspond to the I/O circuit part of the area IOC1 of Figure 1A, and is located in the outermost region of the chip 1. That is, the outer area 3 in Fig. 1B includes output transistors which are connected to an outer reference voltage line which is located outwardly of the bonding pad area PD. The circuitry of the internal cells 2 can be operated without being affected by noise generated in the outer area 3.

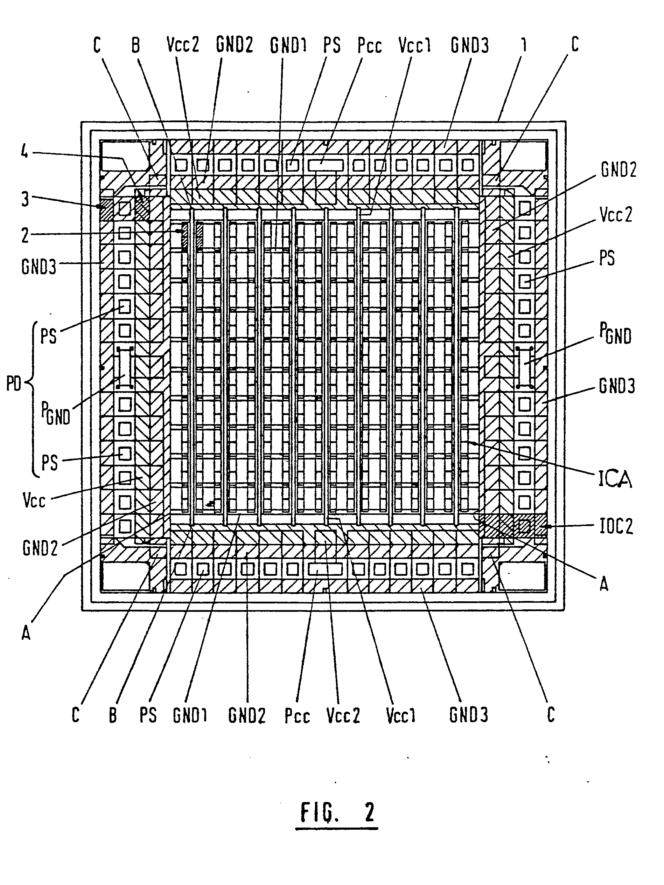

Figure 2 shows in more detail the circuit pattern of Figure 1B. In a central part of the chip 1 the internal cells 2, which are used to construct main logic circuitry, are arranged in a matrix as described above. This part of the chip is the internal cell area ICA. Earth terminals of the internal cells 2 are connected to first inner reference voltage lines GND1 which are provided in the internal cell area ICA to extend laterally of the cell arrays, (i.e. to extend in a row direction with respect to the columnar arrays BL). The first inner reference voltage lines GND1 are spaced from each other with a proper pitch, and are connected to the internal cells arranged in the spacings between the lines. Power supply voltage wiring lines Vcc1 are formed (between the internal cell arrays BL) so as to run across the first inner reference voltage lines GND1. The lines Vcc1 and GND1 are provided in different wiring layers.

There are also provided second inner reference voltage lines GND2, at the edge of the internal cell area as seen in Fig. 2. Both ends of each first inner reference voltage line GND1 are connected to second inner reference voltage lines GND2 at points marked A. Power supply voltage wiring lines Vcc1 are connected to power supply voltage trunk lines Vcc2 at points marked B. The second inner reference voltage lines GND2 are connected to earth potential (earth reference voltage supply) pads $P_{GND}$, and the power supply voltage trunk lines Vcc2 are connected to power supply voltage pads Pcc.

Furthermore, there are outer reference voltage lines GND3 provided at (just within) the periphery or edge of the chip and connected to earth terminals of output transistors which handle large currents and to the earth reference voltage supply pads $P_{GND}$. The outer reference voltage lines GND3 are connected to the second inner reference voltage lines GND2 at points C at the corners of the chip 1, so as to avoid excessive (potential) separation between the inner reference voltage lines GND2 and the outer reference voltage lines GND3.

As can be seen in the Figure 2, the second inner reference voltage lines GND2, the outer reference voltage lines GND3, and power supply voltage trunk lines Vcc2 are arranged around the internal cell area, with a second inner reference voltage line GND2 or power supply voltage trunk line Vcc at the periphery of the internal cell area. These lines are broad (wide) in comparison to the first inner reference voltage lines GND1 and the power supply voltage wiring lines Vcc1 arranged within the internal cell area ICA. The widths of the second inner reference voltage lines GND2 and the outer reference voltages lines GND3 are more than three times that of the first inner reference voltage lines GND1. Also, the width of the power supply voltage trunk lines Vcc2 is more than three times that of the power supply voltage wiring lines Vcc1.

It is important to note that with the layout of Figure 2 first inner reference voltage lines GND1 are separated from outer reference voltage lines GND3 through the bonding pad array (area) so as to·isolate internal cells from noise caused by external cells, i.e. output transistors.

In the layout of Figure 2 the internal cells 2 are separated from the outer area 3 of the external cell area IOC2 by the second inner reference voltage lines GND2, and the outer area 3 is separate from and lies outwardly of the bonding pad area PD. The outer reference voltage lines GND3 and the power supply voltage trunk lines Vcc2 are formed over external cells, but they are insulated from the external cells by insulating film.

As described above, I/O circuits which are provided on the periphery of IC chip in Figure 1B include outer areas 3 in which large current for driving external circuits is handled, and inner areas 4 used for buffers of the I/O circuits and handling rather smaller currents.   As can be seen in Figure 2, outer areas 3 are separated from the internal cell area ICA by second inner reference voltage lines GND2 and power supply voltage trunk lines Vcc2. Moreover, the outer areas 3 are separeated from the inner areas 4 by the bonding pad area, and are located in the outermost area of the chip, surrounded or covered by (as shown)  · the outer reference voltage line GND3. The bonding pad areas PD and, the inner areas 4 lie inside the outer area 3. The former areas are surrounded or covered by the second inner reference voltage line GND2 and bonding pads.   ·

In Fig. 2, Ps indicates bonding pads (signal pads) through which signals are passed.

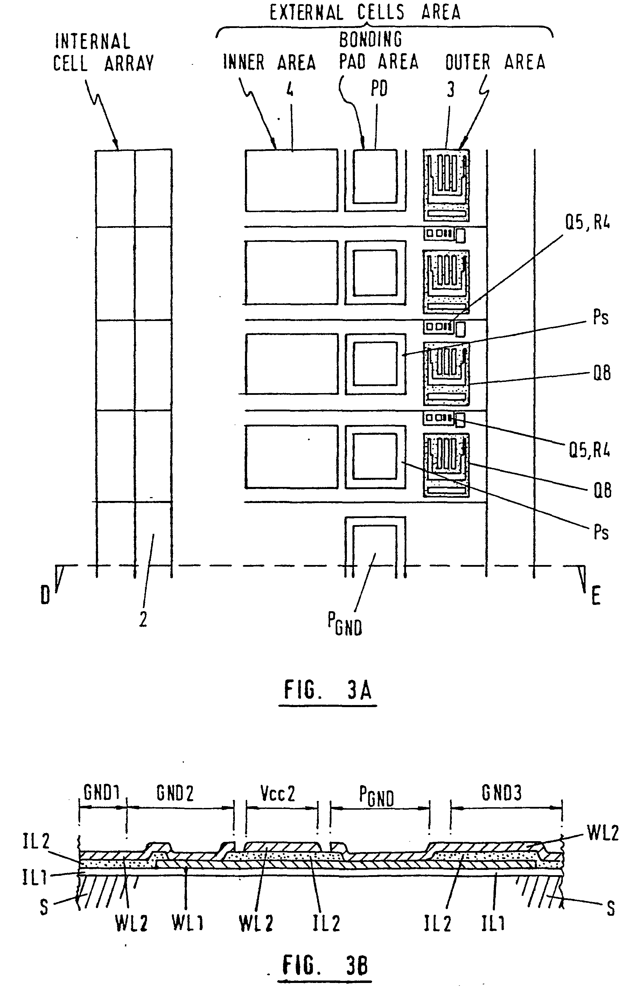

Figure 3A is a schematic view to a larger scale of a part of Figure 2 illustrating in plan the internal cell array area and the external cell area, which includes outer area 3, bonding pad area PD and inner area 4. These three areas of the external cell area are arranged in the stated order progressing outwardly from the internal cell array area. Circuits of the areas 3 are located outermost of the chip. These circuits comprise external output transistors Q8, diodes Q5, and resistors R4 etc. for example. The bonding pad area PD is located inwardly of the outer area 3, and the inner area 4 is located inwardly of the bonding pads ($P_{GND}$ and Ps) in the bonding pad area PD.

Figure 3B is a cross-sectional view, to an enlarged scale, taken along the line D—E in Figure 3A, illustrating the external cell area. This view shows the structure of the multi-layer wiring of the chip over the external cell area comprising outer area 3 and inner area 4, having a plurality of transistors and resistors formed in a semiconductor substrate S, and bonding pad area PD.

As shown in Fig. 3B, an outer reference voltage line GND3, connected to an output transistor (Q8) in the outer area 3, is separated from inner reference voltage lines GND1, GND2, connected to internal cells, by the pad area PD. Each of outer and inner reference voltage lines GND2 and GND3 is connected to the reference bonding pad $P_{GND}$ (directly via wiring layers). GND1 is also connected to the reference bonding pad $P_{GND}$ (directly via wiring layers).

The surface of the substrate S is coated with a first insulating film or layer IL1, such as a silicon dioxide ($SiO_2$) film. A first wiring layer WL1, made of aluminium or polysilicon for example, is fabricated and patterned over the first insulating layer IL1. A second insulating layer IL2 is fabricated and patterned over the first wiring layer WL1. An aluminium film, for example, providing a second wiring layer WL2 is fabricated and patterned over the second insulating layer IL2.

In the reference voltage line GND3 zone of Fig. 3B (indicated by an arrowed line) there are found the aluminium film of the second wiring layer WL2, the second insluating layer IL2, the first wiring layer WL1, the first insulating film IL1 and the semiconductor substrate S of the chip 1 in descending order. In an earth potential pad $P_{GND}$ zone of Fig. 3B there are found the second wiring layer WL2, the first wiring layer WL1, the first insulating film IL1 and the substrate S. In a power supply voltage trunk line Vcc2 zone of Fig. 3B there are found the second wiring layer WL2, the second insulating layer IL2, the first wiring layer WL1, the first insulating film IL1 and the substrate S. In a second inner reference voltage line GND2 zone there are found the second wiring layer WL2, the second insulating layer IL2, the first insulating film IL1 and the substrate S. In a first inner reference voltage line GND1 zone there are found the second wiring layer WL2, the second insulating layer IL2, the first insulating film IL1 and the substrate S.

In this way outer area 3 and inner area 4 are covered by reference voltage lines (and power supply trunk line) but those lines are insulated by insulating layers.

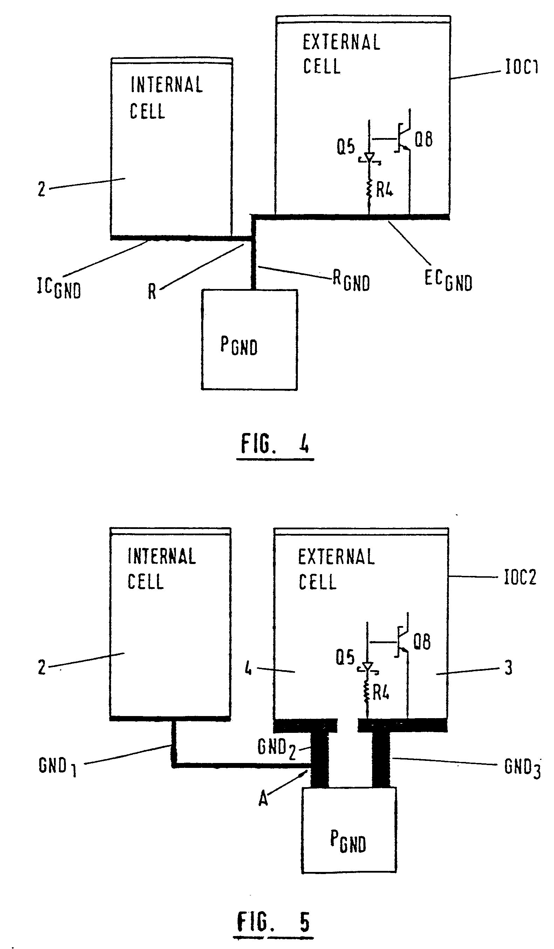

Figure 4 illustrates schematically reference voltage line connection in the pattern layout of a previous LSI circuit. Usually, an earth potential line $EC_{GND}$, as a reference voltage line, of an external cell area IOC1 is connected to an earth potential line $IC_{GND}$ of internal cells 2. An earth line $R_{GND}$ extends from intersection point R of $EC_{GND}$ and $IC_{GND}$ to a pad $P_{GND}$, so that $R_{GND}$ is a common earth line. In such an arrangement, circuitry can often suffer mis-operations caused by noise. The noise is mainly attributed to the switching of high level currents by output transistors included in the IC chip itself, and has been found to be due to potential variation in the common earth line $R_{GND}$.

The potential variation in the common earth line $R_{GND}$ has been found to be caused by the wire resistance of the line, because the common earth line $R_{GND}$ is made of a long and narrow (thin) strip of conductor on the chip.

In an outer region of the external cell area there are included output transistors Q8 which handle large currents. When such large currents rush (flow) to the earth line $EC_{GND}$, the earth potential is varied, and internal cells 2 suffer from noise.

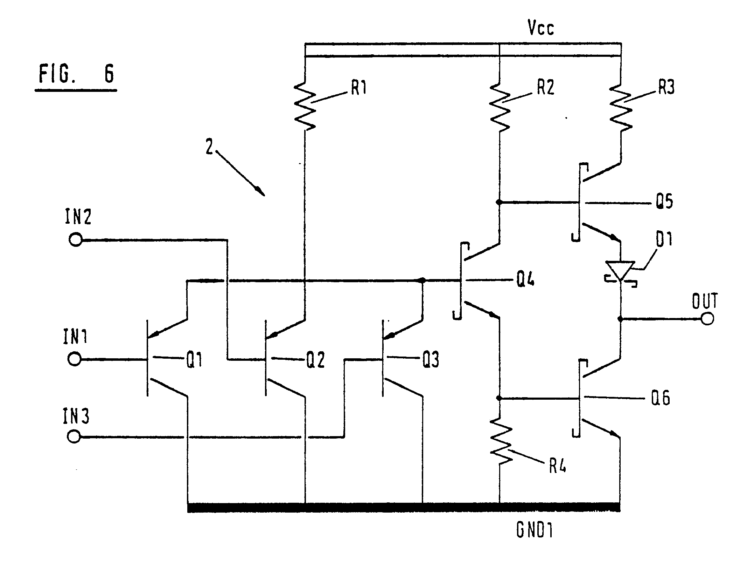

Figure 5 schematically illustrates reference voltage line connections as provided by an embodiment of the present invention. In order to reduce noise, output transistors are fabricated in outer area 3 arranged outwardly of the bonding pads array, and in particular, outer reference voltage line GND3 for the output transistors is located outwardly of the bonding pad array.

Preferably, and as shown, the earth (reference voltage) lines as provided for external cell circuits are separated into two parts. One part is outer reference voltage line GND3, to which output transistors Q8, diodes Q5, and resistors R4 of external cell circuits, corresponding to outer area 3, are connected. The other is provided by inner reference voltage line GND2, which grounds the remainder of the external cell circuits, corresponding to the inner areas 4, of the external cell area.

Thus, the generation of noise in the outer area 3 of the external cell area IOC2 is kept away from the internal cells 2. The circuits of the internal cells 2 can be operated without being affected by the earth potential variation, so the reliability of the device is improved.

Figure 6 is a schematic circuit diagram of an internal cell 2 of the circuit pattern of Figure 2, in which reference voltage line connection is established in accordance with an embodiment of the present invention. The illustrated circuit of the internal cell 2, which is equivalent to a 3-input NAND gate, this being given as a typical circuit configuration for such a cell, comprises gate transistors Q1, Q2, Q3, Q4, Q5 and Q6, a diode D1, resistors R1, R2, R3, and R4, input terminals IN1, IN2, and IN3, and output terminal OUT. All reference voltage line connection are made to a first inner reference voltage line GND1.

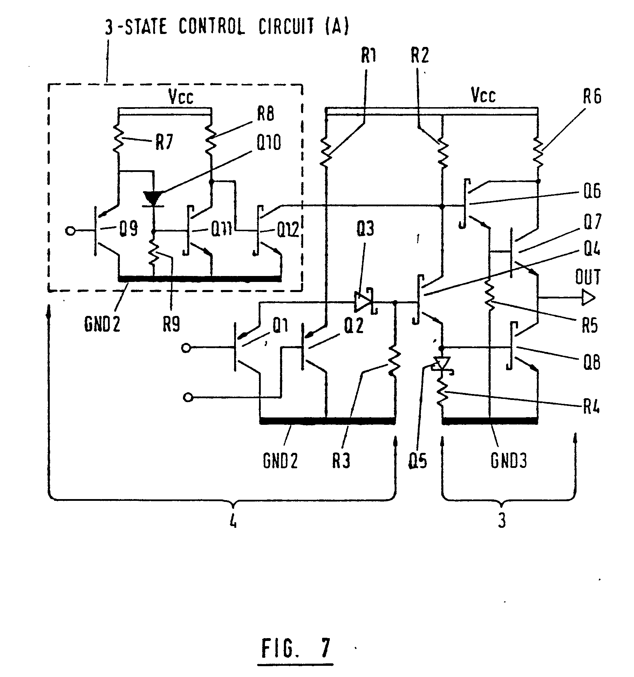

Figure 7 is a schematic circuit diagram of an external cell in accordance with Figure 3 or Figure 5, in which reference the reference voltage line connection is established in accordance with an embodiment of the present invention. The circuit is equivalent to a 3-state output buffer gate. Circuitry in outer area 3 is grounded to an outer reference voltage line GND3, and the remainder of the circuitry, output buffer circuitry, corresponding to inner area 4 is grounded to the second inner reference voltage line GND2.

The circuits of Fig. 6 and 7 are shown simply to illustrate earth potential wiring in accordance with an embodiment of the present invention. The functions of those circuits are not the explicit concern of the present invention and therefore the description of those functions is omitted for simplicity.

Although description of embodiments of the present invention given above has referred to provision of earth potential as a reference voltage (i.e. provision of reference voltage lines connected to a source of fixed low potential) primarily in the context of a TTL gate array LSI, it will be clear that other embodiments can be provided in which other than earth potential is provided as a reference voltage (e.g. a high potential, involving for example provision of reference voltage lines connected to a source of fixed high potential, for instance for an ECL gate array LSI).

An embodiment of the present invention provides a layout for the pattern of a large scale integration (LSI) circuit for reducing noise generated by the driving activity of an output transistor of an IC chip. The LSI circuit has an internal cell area and an external cell area. The internal cell area is arranged in centrally on the chip, and provides main logic circuitry. The external cell area is arranged on outer portions of the chip, and comprises an outer area containing output transistors, an inner area containing input (output) buffer circuits and a bonding pad area containing bonding pads for connecting the IC to external circuits. The outer area is separated from the internal cell area by the bonding pad area, and provided at the outermost region of the chip. When output transistors in the outer area are operated, because of the pattern layout, noise in the outer area is kept away from the internal cell area. Therefore, the circuitry of the internal cell area can be operated without being affected by the noise in the outer area, so reliability is improved.

**Claims**

1. An LSI device chip, having
an internal cell area (ICA), arranged inwardly of the chip, comprising a plurality of internal cells (2), and
an external cell area (IOC2), arranged outwardly of the internal cell area (ICA), comprising a plurality of external cells, with
a bonding pad area (PD), arranged outwardly of the internal cell area (ICA);
an inner reference voltage line (GND1, GND2), arranged inwardly of the bonding pad area, and connected to internal cells, characterised in that
a reference voltage supply pad ($P_{GND}$), to which the inner reference voltage line (GND1, GND2) is connected, is disposed in the bonding pad area (PD),
an outer reference voltage line (GND3) is provided, arranged outwardly of the bonding pad area (PD), connected to said reference voltage supply pad ($P_{GND}$) and to external cells, and
the external cell area (IOC2) comprises an outer area (3) arranged outwardly of the bonding pad area (PD), the bonding pad area (PD), and an inner area (4) arranged inwardly of the bonding pad area (PD).

2. A chip as claimed in claim 1, comprising a first inner reference voltage line (GND1), disposed in the internal cell area (ICA) and connected to the internal cells (2), and
a second inner reference voltage line (GND2), disposed at the outermost edge of the internal cell area (ICA), connected to the first inner reference voltage line (GND1) and connected directly to the reference voltage supply pad ($P_{GND}$), so that the first inner reference voltage line (GND1) is connected to the reference voltage supply pad ($P_{GND}$) via the second inner reference voltage line (GND2).

3. A chip as claimed in claim 1 or 2, wherein the outer reference voltage line (GND3) is disposed towards the outermost edge of the chip and is connected directly to the reference voltage supply pad (P$_{GND}$).

4. A chip as claimed in any preceding claim, wherein output transistors (Q8) of external cells are disposed in the said outer area (3) and are connected to the outer reference voltage line (GND3).

5. A chip as claimed in claim 4 when read as appended to claim 2, wherein circuitry elements of the external cells, other than the output transistors (Q8), are disposed in the said inner area (3) and are connected to the second inner reference voltage line (GND2).

6. A chip as claimed in any preceding claim, wherein the outer reference voltage line (GND3) is formed over or formed at an edge of the said outer area (3).

7. A chip as claimed in any of claims 3 to 6 when read as appended to claim 2, wherein the second inner reference voltage line (GND2) is formed over or formed at an edge of the said inner area (4).

8. A chip as claimed in any preceding claim, wherein the internal cell area (ICA) is provided centrally of the chip, and the external cell area is arranged towards an edge of the chip.

9. A chip as claimed in any preceding claim, having lower voltage power lines and higher voltage power lines, wherein the inner and outer reference voltage lines (GND1, GND2, GND3) are lower voltage power lines.

**Patentansprüche**

1. LSI-Vorrichtungschip, mit
einem internen Zellenbereich (ICA), der innerhalb des Chips angeordnet ist, mit einer Vielzahl von internen Zellen (2), und
einem externen Zellenbereich (IOC2), welcher außerhalb des internen Zellenbereichs (ICA) angeordnet ist und eine Vielzahl von externen Zellen umfaßt, mit
einem Bonding-pad-Bereich (PD), der außerhalb des internen Zellenbereichs (ICA) angeordnet ist;
einer inneren Referenzspannungsleitung (GND1, GND2), die innerhalb des Bonding-pad-Bereichs angeordnet und mit den internen Zellen verbunden ist, dadurch gekennzeichnet, daß
ein Referenzspannungsversorgungspad (P$_{GND}$), mit welchem die innere Referenzspannungsleitung (GND1, GND2) verbunden ist, in dem Bonding-pad-Bereich (PD) angeordnet ist,
eine äußere Referenzspannungsleitung (GND3) vorgesehen ist, die außerhalb des Bonding-pad-Bereichs (PD) angeordnet und mit dem genannten Referenzspannungsversorgungspad (P$_{GND}$) und den äußeren Zellen verbunden ist,
und der externe Zellenbereich (IOC2) einen äußeren Bereich (3), der außerhalb des Bonding-pad-Bereichs (PD) angeordnet ist, den Bonding-pad-Bereich (PD) und einen inneren Bereich (4), der innerhalb des Bonding-pad-Bereichs (PD) angeordnet ist, umfaßt.

2. Chip nach Anspruch 1, mit einer ersten inneren Referenzspannungsleitung (GND1), die in dem internen Zellenbereich (ICA) angeordnet und mit den interen Zellen (2) verbunden ist, und
einer zweiten inneren Referenzspannungsleitung (GND2), die an dem äußersten Rand des inneren Zellenbereiches (ICA) angeordnet ist, mit der ersten inneren Referenzspannungsleitung (GND1) verbunden ist und direkt mit dem Referenzspannungsversorgungspad (P$_{GND}$) verbunden ist, so daß die erste innere Referenzspannungsleitung (GND1) über die zweite innere Referenzspannungsleitung (GND2) mit dem Referenzspannungsversorgungspad (P$_{GND}$) verbunden ist.

3. Chip nach Anspruch 1 oder 2, bei dem die äußere Referenzspannungsleitung (GND3) zum äußersten Rand des Chips hin angeordnet ist und direkt mit dem Referenzspannungsversorgungspad (P$_{GND}$) verbunden ist.

4. Chip nach einem der vorhergehenden Ansprüche, bei dem Ausgangstransistoren (Q8) der externen Zellen in dem genannten äußeren Bereich (3) angeordnet und mit der äußeren Referenzspannungsleitung (GND3) verbunden sind.

5. Chip nach Anspruch 4, in Verbindung mit Anspruch 2, bei dem die Schaltungselemente der externen Zellen, abgesehen von dem Ausgangstransistor (Q8), in dem genannten inneren Bereich (3) angeordnet und mit der zweiten inneren Referenzspannungsleitung (GND2) verbunden sind.

6. Chip nach einem der vorhergehenden Ansprüche, bei dem die äußere Referenzspannungsleitung (GND3) über oder an einem Rand des genannten äußeren Bereichs (3) gebildet ist.

7. Chip nach einem der Ansprüche 3 bis 6, in Verbindung mit Anspruch 2, bei dem die zweite innere Referenzspannungsleitung (GND2) über oder an einem Rand des genannten inneren Bereichs (4) gebildet ist.

8. Chip nach einem der vorhergehenden Ansprüche, bei dem der innere Zellenbereich (ICA) im Zentrum des Chips vorgesehen ist, und der externe Zellenbereich zum Rand des Chips hin angeordnet ist.

9. Chip nach einem der vorheregeheneden Ansprüche, welches Energieleitungen niedriger Spannung und Energieleitungen höherer Spannung hat, wobei die inneren und äußeren Referenzspannungsleitungen (GND1, GND2, GND3) Energieleitungen niedrigerer Spannung sind.

**Revendications**

1. Puce de dispositif LSI comprenant:
une zone de cellules internes (ICA), disposée à l'intérieur de la puce comprenant une pluralité de cellules internes (2), et
une zone de cellules externes (IOC2) disposée à l'extérieur de la zone de cellules internes (ICA) comprenant une pluralité de cellules externes, avec
une zone de plots de liaison (PD), disposée vers l'extérieur de la zone de cellules internes (ICA);

une ligne de tension de référence interne (GND1, GND2) disposé à l'intérieur de la zone de plots de liaison, et connectée aux cellules internes, caractérisée en ce que:

un plot d'alimentation de tension de référence ($P_{GND}$), auquel la ligne de tension de référence interne (GND1, GND2) est connectée, est disposé dans la zone de plots de liaison (PD),

une ligne de tension de référence externe (GND3) est prévue, disposée à l'extérieur de la zone de plots de liaison (PD) connectée au plot d'alimentation de tension de référence ($P_{GND}$) et aux cellules externes, et

la zone de cellules externes (IOC2) comprend une zone externe (3) disposée à l'extérieur de la zone de plots de liaison (PD), la zone de plots de liaison (PD), et une zone interne (4) disposée à l'intérieur de la zone de plots de liaison (PD).

2. Puce selon la revendication 1, comprenant une première ligne de tension de référence interne (GND1) disposée dans la zone de cellules internes (ICA) et connectée aux cellules internes (2), et

une seconde ligne de tension de référence interne (GND2) disposée sur le bord le plus externe de la zone de cellules internes (ICA) connectée à la première ligne de tension de référence interne (GND1) et connectée directement au plot d'alimentation de tension de référence ($P_{GND}$), de sorte que la première ligne de tension de référence interne (GND1) est connectée au plot d'alimentation de tension de référence ($P_{GND}$) par l'intermédiaire de la seconde ligne de tension de référence interne (GND2).

3. Puce selon l'une des revendications 1 ou 2, dans laquelle la ligne de tension de référence externe (GND3) est disposée vers le bord le plus

externe de la puce et est connectée directement au plot d'alimentation de tension de référence ($P_{GND}$).

4. Puce selon l'une des revendications précédentes, dans laquelle des transistors de sortie (Q8) des cellules externes sont disposées dans la zone externe (3) et sont connectées à la ligne de tension de référence externe (GND3).

5. Puce selon la revendication 4, prise dans son rattachement à la revendication 2, dans laquelle des éléments de circuit des cellules externes, autres que les transistors de sortie (Q8), sont disposés dans la zone interne (3) et sont connectés à la seconde ligne de tension de référence interne (GND2).

6. Puce selon l'une quelconque des revendications précédentes, dans laquelle la ligne de tension de référence externe (GND3) est formée sur ou formée au niveau d'un bord de la zone externe (3).

7. Puce selon l'une quelconque des revendications 3 à 6 prises dans leur rattachement avec la revendication 2, dans laquelle la seconde ligne de tension de référence interne (GND2) est formée sur ou au niveau d'un bord de la zone interne (4).

8. Puce selon l'une quelconque des revendications précédentes dans laquelle la zone de cellules internes (ICA) est prévue de façon centrale par rapport à la puce et la zone de cellules externes est disposée vers un bord de la puce.

9. Puce selon l'une quelconque des revendications précédentes comprenant des lignes d'alimentation en tensions inférieures et des lignes d'alimentation en tensions supérieures, dans laquelle les lignes de tension de référence interne et externe (GND1, GND2, GND3) sont les lignes d'alimentation en tensions inférieures.

BL1  BL2      BLn

FIG. 1A

BL1  BL2      BLn

FIG. 1B

FIG. 2

# 0 136 888

EXTERNAL CELLS AREA

INTERNAL CELL ARRAY

INNER AREA 4 — BONDING PAD AREA PD — OUTER AREA 3

Q5, R4

Ps

Q8

Q5, R4

Q8

Ps

D

E

2

P_{GND}

## FIG. 3A

GND1 | GND2 | Vcc2 | P_{GND} | GND3

IL2
IL1
S

WL2

WL2 | WL1 | WL2 | IL2 | IL2 | IL1

S

## FIG. 3B

3

INTERNAL CELL

EXTERNAL CELL

IOC1

2

Q5 Q8

R4

ICGND

R

RGND

ECGND

PGND

FIG. 4

INTERNAL CELL

EXTERNAL CELL

IOC2

2

4

Q5 Q8

R4

3

GND1

GND2

GND3

A

PGND

FIG. 5

4

FIG. 6

3-STATE CONTROL CIRCUIT (A)

FIG. 7